(19) Europäisches Patentamt
European Patent Office
Office européen des brevets

(11) **EP 1 835 551 B1**

(12) **EUROPEAN PATENT SPECIFICATION**

(45) Date of publication and mention
of the grant of the patent:
**24.01.2018 Bulletin 2018/04**

(51) Int Cl.:
*H01L 35/08* (2006.01)          *H01L 35/14* (2006.01)
*H01L 35/30* (2006.01)          *H02N 11/00* (2006.01)

(21) Application number: **05814548.3**

(86) International application number:
**PCT/JP2005/022759**

(22) Date of filing: **12.12.2005**

(87) International publication number:
**WO 2006/067986 (29.06.2006 Gazette 2006/26)**

(54) **THERMOELECTRIC CONVERSION MODULE, HEAT EXCHANGER USING SAME, AND THERMOELECTRIC POWER GENERATING SYSTEM**

THERMOELEKTRISCHES WANDLERMODUL, WÄRMETAUSCHER DAMIT UND THERMOELEKTRISCHES STROMERZEUGUNGSSYSTEM

MODULE DE CONVERSION THERMOELECTRIQUE, ECHANGEUR DE CHALEUR UTILISANT CELUI-CI ET SYSTEME DE GENERATION D'ENERGIE THERMOELECTRIQUE

(84) Designated Contracting States:
**CH DE FR GB IT LI**

(30) Priority: **20.12.2004 JP 2004367790**

(43) Date of publication of application:
**19.09.2007 Bulletin 2007/38**

(73) Proprietors:
• **Kabushiki Kaisha Toshiba**
**Tokyo 105-8001 (JP)**
• **Toshiba Materials Co., Ltd.**
**Yokohama-shi, Kanagawa 235-8522 (JP)**

(72) Inventors:
• **HIRONO, Shinsuke**
Int. Prop. Division
Toshiba Corp.
Tokyo 1058001 (JP)
• **NABA, Takayuki**
Int. Prop. Division
Toshiba Corp.
Tokyo 1058001 (JP)
• **OKAMURA, Masami**
Int. Prop. Division
Toshiba Corp.
Tokyo 1058001 (JP)

(74) Representative: **Hoffmann Eitle**
**Patent- und Rechtsanwälte PartmbB**
**Arabellastraße 30**
**81925 München (DE)**

(56) References cited:
WO-A1-2004/095594          JP-A- 11 068 172
JP-A- 11 068 172              JP-A- 2001 028 462
JP-A- 2002 203 993          JP-A- 2003 282 796
JP-A- 2003 282 796          JP-A- 2004 356 607
US-A- 5 429 680              US-A- 5 807 626
US-A1- 2002 179 135

• SPORTOUCH S ET AL: "Thermoelectric properties of half-heusler phases: ErNi1-xCuxSb, YNi1-xCuxSb and ZrxHfyTizNiSn", EIGHTEEN INTERNATIONAL CONFERENCE ON THERMOELECTRICS, 1999, PISCATAWAY, NJ, USA, IEEE, US, 29 August 1999 (1999-08-29), pages 344-347, XP010379392,

Remarks:
The file contains technical information submitted after the application was filed and not included in this specification

**Description**

TECHNICAL FIELD

The present invention relates to a thermoelectric conversion module using a thermoelectric material including as a main phase an intermetallic compound having an MgAgAs crystalline structure, a heat exchanger using it, and a thermoelectric power generating apparatus.

BACKGROUND ART

Resource depletion is expected, and it is a very significant issue to consider how energy is used effectively, and various types of systems have been proposed. Among them, a thermoelectric element is expected as a device which recovers energy which has been abandoned uselessly into the environment as exhaust heat. The thermoelectric element is used as a thermoelectric conversion module which has p-type thermoelectric elements (p-type thermoelectric semiconductors) and n-type thermoelectric elements (n-type thermoelectric semiconductors) alternately connected in series.

For example, a conventional waste heat boiler is designed in order to merely obtain steam or hot water by passing through a heat exchanger, and power for that operation is introduced from outside. In this connection, it is tried to incorporate the thermoelectric conversion module into a waste heat boiler to obtain power from waste heat in these years. In view of usability of a higher temperature heat source, it is desirable that the used thermoelectric element has a higher usable temperature (a temperature range that practical thermoelectric conversion efficiency can be obtained). Especially, to use awaste heat boiler for power generation, it is desirable to apply a thermoelectric element having a usable temperature of 300°C or more.

Thermoelectric materials being used practically for conventional thermoelectric conversion modules are mostly Bi-Te based (including those with Sb or Se added as a third element) thermoelectric semiconductors, and other materials were used for special usages but not used for industrial production. The above-described Bi-Te based thermoelectric semiconductors have a usable temperature of up to 200°C and are effective for cooling devices and the like using the Peltier effect but cannot be used for the thermoelectric element of a power generating system used for a waste heat boiler or the like.

Meanwhile, the thermoelectric material (hereinafter referred to as the half-Heusler material) having as a main phase an intermetallic compound with an MgAgAs crystalline structure shows semiconductor properties and is watched with interest as a novel thermoelectric conversion material. Some of the intermetallic compounds having the MgAgAs crystalline structure are reported that they shows a high Seebeck effect under room temperature (see, for example, Non-patent Reference 1). And, the half-Heusler material has a high usable temperature and is expected to improve the thermoelectric conversion efficiency, so that it is an attractive material for the thermoelectric conversion module of the power generating system using a high temperature heat source.

To use the half-Heusler material for the power generating system or the like, it is important to realize a highly reliable module structure capable of resisting to a high temperature. For the thermoelectric conversion module using the conventional Bi-Te based thermoelectric element, structures for improving the reliability of the module structure have been proposed. For example, Patent Reference 1 describes a method that cream solder is coated on the electrode surface by screen printing and the electrode and the thermoelectric element are bonded with the cream solder. Patent Reference 2 describes a method that a conductive film (electroless Ni-plated layer, etc.) is previously formed on the bonding surfaces of thermoelectric elements, and the electrode is soldered with the conductive film with the conductive film interposed between them. Patent Reference 3 describes that a silicon nitride ceramics substrate is used for an insulating substrate for supporting the electrodes.

To improve the practical utility of the thermoelectric conversion module, it is necessary to improve the reliability (reliability in terms of a mechanical stress and a thermal stress) of the bonding parts between the electrodes and the thermoelectric elements formed of the half-Heusler material, and it is further necessary to improve the electrical conductivity of the bonding parts. However, for example, soldering described in Patent References 1 and 2 cannot satisfy the heat resistance that the thermoelectric conversion module using a high-temperature heat source is required to have. As a result, bonding reliability or the like between the thermoelectric elements and the electrodes is degraded. Thus, a bonding method capable of improving reliability, electrical conductivity, thermal conductance and the like of bonding parts for the thermoelectric elements made of the half-Heusler material and the electrodes has not been found, and a thermoelectric conversion module excelling in practical utility has not been obtained.

Patent Reference 4 discloses a method for making a thermoelectric converter module 1 having junctions wherein a p-type thermoelectric semiconductor 3, electrodes 6 and 7, and an n-type thermoelectric semiconductor 2 are electrically joined. Thereon, the junctions are formed using junction materials 4 and 5 of Ag or junction materials 4 and 5 wherein Ag content is over 85 wt.% and the remainder consists of more than one element selected between Mn, Cr, V, and Ti in the junctions of the p-type thermoelectric semiconductor 3, the n-type thermoelectric semiconductor 2, and the electrodes 6 and 7 of which major constituents are Si-Ge.

Non-Patent Reference 5 discloses a thermoelectric element made of the Half-Heusler material including as a main phase an intermetallic compound having an MgAgAs crystalline structure.

Non-Patent Reference 1: J. Phys. Condens. Matter 11 1697-1709 (1999)

Patent Reference 1: JP-A 2001-168402 (KOKAI)
Patent Reference 2: JP-A 2001-352107 (KOKAI)
Patent Reference 3: JP-A 2002-203993 (KOKAI)
Patent Reference 4: JP 11 068172

Non-Patent Reference 5: SPORTOUCH S ET AL: "Thermoelectric properties of half-heusler phases: ErNi1-xCuxSb, YNi1-xCuxSb and ZrxHfyTizNiSn",EIGHTEEN INTERNATIONAL CONFERENCE ON THERMOELECTRICS, 1999, PISCATAWAY, NJ, USA, IEEE, US, 29 August 1999 (1999-08-29), pages 344-347, XP010379392,

DISCLOSURE OF THE INVENTION

An object of the invention is to provide a thermoelectric conversion module of which practical utility as a module is enhanced by improving reliability, electrical conductivity, thermal conductance and the like of bonding parts for thermoelectric elements made of a half-Heusler material and electrodes, and a heat exchanger using the thermoelectric conversion module and a thermoelectric power generating apparatus.

A thermoelectric conversion module according to an aspect of the invention comprises:

A thermoelectric conversion module, comprising:

a first electrode member arranged on a high-temperature side;
and a second electrode member arranged on a low-temperature side to face the first electrode member;
a thermoelectric element arranged between the first electrode member and the second electrode member and made of a thermoelectric material including as a main phase an intermetallic compound having an MgAgAs crystalline structure ; and
bonding parts for electrically and mechanically connecting the thermoelectric element to the first and second electrode members, and including a bonding material which contains [at least one selected from Ag, Cu and] an Ag-Cu alloy or Ni as a main component and at least one [of] active metal selected from Ti, Zr, Hf, Ta, V and Nb in a range of 1% by mass or more and 10% by mass or less,
characterized in that:
the first electrode material is made of a metal material which contains at least one element selected from Cu, Ag and Fe;
the second electrode material is made of a metal material which contains at least one element selected from Cu, Ag and Fe;
the thermoelectric material has a composition represented by a general formula:

$$A_xB_yX_{100-x-y}$$

where, A is at least one element selected from group 3 elements, group 4 elements and group 5 elements, B is at least one element selected from group 7 elements, group 8 elements, group 9 elements and group 10 elements, X is at least one element selected from group 13 elements, group 14 elements and group 15 elements, and x and y are numerals satisfying $25{\leq}x{\leq}50$ atomic percent, $25{\leq}y{\leq}50$ atomic percent and $x+y{\leq}75$ atomic percent.

A heat exchanger according to another aspect of the invention comprises a heating surface, a cooling surface, and the thermoelectric conversion module arranged between the heating surface and the cooling surface and in accordance with the aspect of the invention. A thermoelectric power generating apparatus according to still another aspect of the invention comprises the heat exchanger according to the aspect of the invention, and a heat supply portion for supplying the heat exchanger with heat, wherein the heat supplied by the heat supply portion is converted into electric power by the thermoelectric conversion module of the heat exchanger to generate power.

BRIEF DESCRIPTION OF THE DRAWINGS

[FIG.1] FIG. 1 is a sectional view schematically showing a structure of a thermoelectric conversion module according to an embodiment of the invention.

[FIG. 2] FIG. 2 is a diagram showing a crystalline structure of an MgAgAs type intermetallic compound.

[FIG. 3] FIG. 3 is a sectional view showing a modified example of the thermoelectric conversion module shown in Fig. 1.

[FIG. 4] FIG. 4 is a sectional view showing a schematic structure of a heat exchanger according to an embodiment of the invention.

[FIG. 5] FIG. 5 is a diagram showing a schematic structure of a waste incineration system to which a thermoelectric power generating apparatus according to an embodiment of the invention is applied.

[FIG. 6A] FIG. 6A is an SEM image showing a state of bonded interface between a thermoelectric element and an electrode plate of a thermoelectric conversion module of Example 1.

[FIG. 6B] FIG. 6B is an element mapping view of Ti according to EPMA of the same portion as Fig. 6A.

[FIG. 6C] FIG. 6C is an explanatory view of Fig. 6B.

[FIG. 7A] FIG. 7A is an SEM image showing the bonded interface between a thermoelectric element and an electrode plate of a thermoelectric conversion module of Comparative Example 1.

[FIG. 7B] FIG. 7B is an elemental mapping view of Ti according to EPMA of the same portion as Fig. 7A.

[FIG. 7C] FIG. 7C is an explanatory view of Fig. 7B.

[FIG. 8] FIG. 8 is an SEM image showing a state of an interface between a thermoelectric element and a bonding material of a thermoelectric conversion module of Example 40.

[FIG. 9] FIG. 9 is an SEM image showing a state of an interface between a thermoelectric element and a bonding material of a thermoelectric conversion module of Example 48.

## EXPLANATION OF NUMERALS

11: p-Type thermoelectric element, 12: n-Type thermoelectric element, 13: First electrode member, 14: Second electrode member, 15, 16: Insulating heat-conducting plate, 17, 18, 21: Bonding part, 19, 20: Backing metal plate, 30: Heat exchanger, 40: Exhaust heat utilization power generating system.

## MODE FOR CARRYING OUT THE INVENTION

Modes of conducting the present invention will be described with reference to the drawings. Embodiments of the present invention are described with reference to the drawings, which are provided for illustration only, and the present invention is not limited to the drawings.

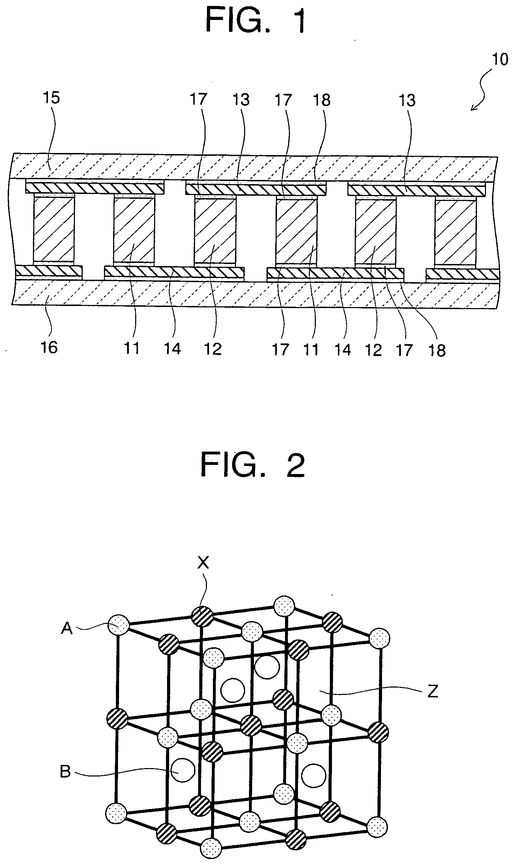

Fig. 1 is a sectional view showing a structure of a thermoelectric conversion module according to an embodiment of the invention. A thermoelectric conversion module 10 shown in Fig. 1 has plural p-type thermoelectric elements 11 and plural n-type thermoelectric elements 12. The p-type thermoelectric elements 11 and the n-type thermoelectric elements 12 are alternately arranged on the same plane, and they are arranged in matrix as the whole module to configure a thermoelectric element group. Each p-type thermoelectric element 11 has the n-type thermoelectric element 12 next to it.

The p-type thermoelectric elements 11 and the n-type thermoelectric elements 12 are made of a thermoelectric material (half-Heusler material) including as a main phase an intermetallic compound having an MgAgAs crystalline structure. The main phase indicates a phase having the highest volume fraction among the phases configured. The half-Heusler material is watched with interest as a novel thermoelectric conversion material, and has high thermoelectric performance. The half-Heusler compound is an intermetallic compound expressed by a chemical formula ABX and has an MgAgAs crystalline structure of a cubic system. The half-Heusler compound has a crystalline structure having B atoms inserted into NaCl-type crystal lattice according to A atoms and X atoms as shown in Fig. 2. In Fig. 2, Z denotes pores.

The half-Heusler material has a high Seebeck coefficient at room temperature. The above-described Non-patent Reference 1 has reported the Seebeck coefficients of the half-Heusler compounds at room temperature. For example, a TiNiSn compound is -142 $\mu$V/K, ZrNiSn is -176 $\mu$V/K, and HfNiSn is -124 $\mu$V/K. The half-Heusler compound is a general term for compounds having the MgAgAs crystalline structure as shown in Fig. 2, and many types are known as the elements configuring the ABX.

As an A site element of the half-Heusler compound, at least one of element selected from group 3 elements (rare earth elements including Sc, Y, etc.), group 4 elements (Ti, Zr, Hf, etc.), and group 5 elements (V, Nb, Ta, etc.) is generally used. As a B site element, at least one of element selected from group 7 elements (Mn, Tc, Re, etc.), group 8 elements (Fe, Ru, Os, etc.), group 9 elements (Co, Rh, Ir, etc.), and group 10 elements (Ni, Pd, Pt, etc.) is used. As an X site element, at least one of element selected from group 13 elements (B, Al, Ga, In, Tl), group 14 elements (C, Si, Ge, Sn, Pb, etc.), and group 15 elements (N, P, As, Sb, Bi) is used.

As the half-Heusler compound, a compound having a composition which is substantially expressed by a general formula:

$$A_x B_y X_{100-x-y} \quad \cdots \quad (1)$$

(wherein, A denotes at least one element selected from 3 group elements, group 4 elements and group 5 elements, B denotes at least one element selected from group 7 elements, group 8 elements, group 9 elements and group 10 elements, X denotes at least one element selected from group 13 elements, group 14 elements and group 15 elements, and x and y denote numerals satisfying $25 \leq x \leq 50$ atomic%, $25 \leq y \leq 50$ atomic% and $x+y \leq 75$ atomic%) is used.

For the p-type thermoelectric element 11 and the n-type thermoelectric element 12, a material having as a main phase the half-Heusler compound expressed by the formula (1) is applied. As such a half-Heusler compound, it is particularly preferable to apply a compound having a composition substantially represented by a general formula:

$$A1_x B1_y X1_{100-x-y} \quad \cdots (2)$$

(wherein, **A1** denotes at least one element selected from Ti, Zr, Hf and rare earth element, B1 denotes at least one element selected from Ni, Co and Fe, X1 denotes at least one element selected from Sn and Sb, and x and y denote numerals satisfying $30 \leq x \leq 35$ atomic% and $30 \leq y \leq 35$ atomic%).

In addition, the half-Heusler compound applied to the p-type and n-type thermoelectric elements 11, 12 desirably has a composition substantially represented by a general formula:

$$(Ti_a Zr_b Hf_c)_x B1_y X1_{100-x-y} \quad \cdots (3)$$

(wherein, a, b, c, x and y denote numerals satisfying $0 \leq a \leq 1$, $0 \leq b \leq 1$, $0 \leq c \leq 1$, $a+b+c=1$, $30 \leq x \leq 35$ atomic% and $30 \leq y \leq 35$ atomic%).

The half-Heusler compounds expressed by the formula (2) and the formula (3) show a particularly high Seebeck effect and have a high usable temperature (specifically, 300°C or more). Therefore, they are effective as the thermoelectric elements 11, 12 of the thermoelectric conversion module 10 used for power generating systems using a high-temperature heat source. In the formula (2) and the formula (3), an amount (x) of A site (or A1 site) element is preferably in a range of 30 to 35 atomic% in order to obtain a high Seebeck effect. Similarly, an amount (y) of B site (or B1 site) element is also preferably in a range of 30 to 35 atomic%.

As the rare earth element configuring the A site (or A1 site) element, it is preferable to use Y, La, Ce, Pr, Nd, Sm, Gd, Tb, Dy, Ho, Er, Tm, Yb, Lu and the like. In the formula (2) and the formula (3), the A site (or A1 site) element may be partly replaced with V, Nb, Ta, Cr, Mo, W or the like. The B site element (or B1 site) may be partly replaced with Mn, Cu or the like. The X site (or X1 site) element may be partly replaced with Si, Mg, As, Bi, Ge, Pb, Ga, In or the like.

A first electrode member 13 is arranged on the tops of one p-type thermoelectric element 11 and its adjacent one n-type thermoelectric element 12 to connect them. Meanwhile, a second electrode member 14 is arranged in contact with the bottoms of the p-type thermoelectric element 11 and its adjacent n-type thermoelectric element 12 to connect them. The first electrode member 13 and the second electrode member 14 are arranged in a state displaced by one device. Thus, the plural p-type thermoelectric elements 11 and the n-type thermoelectric elements 12 are electrically connected in series. In other words, the first and second electrode members 13, 14 are arranged so that DC current flows through the p-type thermoelectric element 11, the n-type thermoelectric element 12, the p-type thermoelectric element 11, the n-type thermoelectric element 12, ... sequentially.

The first and second electrode members 13, 14 are made of a metal material which mainly contains at least one selected from Cu, Ag and Fe. Since the metal material is soft, it serves to relieve a thermal stress when bonded to the thermoelectric elements 11, 12 made of the half-Heusler material. Therefore, the thermal-stress reliability of the bonding parts between the first and second electrode members 13, 14 and the thermoelectric elements 11, 12, for example, a heat cycle property, can be enhanced. In addition, the metal material which mainly contains Cu, Ag and Fe excels in electrical conductivity, so that power generated by, for example, the thermoelectric conversion module 10 can be taken efficiently.

A top insulating heat-conducting plate 15 which is commonly bonded to the electrode members 13 is arranged on the outside surfaces (surfaces opposite to the surfaces bonded to the thermoelectric elements 11, 12) of the first electrode members 13. Meanwhile, a bottom insulating heat-conducting plate 16 which is commonly bonded to the electrode members 14 is also arranged on the outside surfaces of the second electrode members 14. In other words, the first and second electrode members 13, 14 each are supported by the insulating heat-conducting plates 15, 16 to maintain the module structure.

The insulating heat-conducting plates 15, 16 are preferably made of an insulating ceramics plate. For the insulating heat-conducting plates 15, 16, it is desirable to use a ceramics plate made of a sintered body which mainly contains at least one selected from aluminum nitride, silicon nitride, silicon carbide, alumina and magnesia excelling in thermal conductance. Especially, it is desirable to use a high thermal conductive silicon nitride substrate (silicon nitride base sintered body) having a thermal conductivity of 65 W/m·K or more and a three point bending strength of 600 MPa or more as described in the above-described JP-A 2002-203993 (KOKAI).

The first and second electrode members 13, 14 and the p-type and n-type thermoelectric elements 11, 12 are bonded via bonding parts 17. In other words, the p-type and n-type thermoelectric elements 11, 12 are electrically and mechanically connected to the first and second electrode members 13, 14 via the bonding parts 17. The bonding parts 17 are made of a bonding material (active metal-containing bonding material) which contains at least one selected fromAg, Cu and Ni as a main component and at least one of active metal selected from Ti, Zr, Hf, Ta, V and Nb in a range of 1% by mass or more and 10% by mass or less.

The active metal-containing bonding material forming the bonding parts 17 shows good wettability to the thermoelectric elements 11, 12 made of the half-Heusler material and forms a firm bonded interface structure. Besides, a volume of pores (holes) generated within the interface between the thermoelectric elements 11, 12 and the bonding parts 17 and within the bonding parts 17 can be decreased. Therefore, the application of the bonding parts 17 made of the active metal-containing bonding material enables to firmly bond mechanically the thermoelectric elements 11, 12 and the electrode members 13, 14 and can realize the bonding parts 17 which does not suffer from a large electrical loss, thermal loss or the like in the bonded interface.

The active metal-containing bonding material was applied on the basis of the following background. Specifically, to configure the thermoelectric conversion module 10 using the thermoelectric elements 11, 12 made of the half-Heusler material, it is necessary to realize a practical bonding structure with the electrode members 13, 14, namely a bonding structure with firm bonding with the electrode members 13, 14 and without a large electrical loss or thermal loss between them. In this connection, it was found that the half-Heusler material had a very poor bonding property with another material and that it was hard to obtain a good bonded state by a general method of bonding with the electrode members.

For example, an Ag brazing usable as the bonding material at a high temperature was used to check the bonding property to the electrode members made of Ag, Cu or the like, and it was found that firmbondingwith the electrode materials could not be obtained because the wettability of the brazing material with the half-Heusler material was very poor. And, even if flux such as boric acid was used, it was difficult to improve the bonded state significantly. It is presumed that the half-Heusler material has a covalent bonding as a bonding mode, so that the wettability of the Ag brazing is poor, resulting in difficulty in bonding.

As another bonding method, a diffusion bonding method not using a brazing material was studied to find that a bonding strength of a level which cannot be separated by human power can be obtained by bonding with an SUS electrode member with an Al foil interposed as an intermediate material. But, when a power generation test was performed for several minutes according to the above bonding method with a temperature difference of about 400°C between both ends of the bonded body, separation was caused at the bonded interface between the electrode members and the thermoelectric elements made of the half-Heusler material. Such a module has instable output because bonding was not performed properly, and the module has low energy conversion efficiency.

Thus, the thermoelectric elements made of the half-Heusler material can be used up to a high temperature and has high thermoelectric conversion performance, but it has a drawback that it is hardly formed as a module because the bonding property with another member is poor. If the thermoelectric elements made of the half-Heusler material cannot be bonded with the electrode members sufficiently, a practically usable thermoelectric conversion module cannot be realized. In other words, if the half-Heusler material having high thermoelectric performance and a good bonding method with it could be satisfied at the same time, it is possible to realize a thermoelectric conversion module functional satisfactorily at a high temperature of, for example, 300°C or higher.

Accordingly, as a result of studying on a bonding method effective for the half-Heusler material, it was found that the thermoelectric elements 11, 12 made of the half-Heusler material and the electrode members 13, 14 could be bonded firmly by using a bonding material containing at least one selected from Ti, Zr, Hf, Ta, V and Nb as an active metal without a special preprocessing. Since the bonding material contains the active metal, the wettability to the half-Heusler material is improved significantly, enabling to bond firmly with the electrode members 13, 14 can be made.

In a case where the active metal-containing bonding material is used, an alloy layer of the active metal in the bonding material and the constituent element of the thermoelectric elements 11, 12 is readily formed in the interface between the thermoelectric elements 11, 12 made of the half-Heusler material and the bonding parts 17. The constituent element of the thermoelectric elements 11, 12 forming the alloy layer includes at least one element selected from, for example, Ni, Co, Fe, Y, La, Ce, Pr, Nd, Sm, Gd, Tb, Dy, Ho, Er, Tm, Yb, Lu, Sn and Sb. The formation of the alloy layer on the bonded interface causes the bonding material layer 17 to intricate into the thermoelectric elements 11, 12.

By realizing the above interface structure, the thermoelectric elements 11, 12 made of the half-Heusler material can be bonded firmly with the bonding parts 17 and accordingly with the electrode members 13, 14. In addition, the alloy layer formed on the bonded interface not only improves adhesiveness between the thermoelectric elements 11, 12 and the bonding parts 17, but also functions as a conductive material, so that the thermoelectric elements 11, 12 and the electrode members 13, 14 can be finely connected electrically. In other words, electrical contact resistance between the thermoelectric elements 11,12 made of the half-Heusler material and the electrode members 13, 14 can be decreased. In addition, the thermal conductance is also improved, and the thermal resistance between the thermoelectric elements 11, 12 and the electrode members 13, 14 can be decreased.

In addition, the bonding parts 17 using the active metal-containing bonding material contribute to the reduction of the pores present in the interface with the thermoelectric elements 11, 12 and within the bonding parts 17. In other words, the ratio of pores present in the interface between the thermoelectric elements 11, 12 and the bonding parts 17 and in the bonding parts 17 can be decreased to 10% (area ratio) or below. The reduction of the pores within the bonded interface and the bonding parts 17 lowers the thermal resistance between the thermoelectric elements 11, 12 and the electrode members 13, 14. Therefore, heat (temperature difference) for obtaining power can be conducted efficiently to the thermoelectric elements 11, 12. In addition, the electrical contact resistance is also reduced, so that internal resistance of the thermoelectric conversion module 10 as a whole can be decreased.

According to the thermoelectric conversion module 10 having the interface structure as described above, energy conversion efficiency can be improved on the basis of the reduction or the like of the thermal resistance and the electrical contact resistance between the thermoelectric elements 11, 12 and the electrode members 13, 14. The ratio of the pores in the bonded interface and the bonding parts 17 is preferably 5% or less, and more preferably 3% or less. As described in detail later, the ratio of the pores is calculated as a ratio of a pore area to a total area of the bonded interface and the bonding parts 17 by determining a total area of the pores present in the bonded interface between the thermoelectric elements 11, 12 and the bonding parts 17 and in the bonding parts 17.

To the bonding parts between the thermoelectric elements 11, 12 and the electrode members 13, 14 of the thermoelectric conversion module 10 are applied a thermal stress involved in ON and OFF of the thermoelectric conversion module 10 in addition to a mechanical stress involved at the time of assembling, mounting and the like. The above-described active metal-containing bonding material can provide the bonding parts 17 excelling in reliability in terms of a mechanical stress or a thermal stress. In addition, the bonding parts 17 between the thermoelectric elements 11, 12 and the electrode members 13, 14 become not only mechanical bonding parts when the module is simply formed but also become electrical bonding parts when a potential difference generated between the p-type thermoelectric elements 11 and the n-type thermoelectric elements 12 which are connected in series is derived as power.

If the electrical bonding parts have a high contact resistance, power deriving efficiency, namely thermoelectric conversion efficiency, is degraded. As described above, the electrical contact resistance between the thermoelectric elements 11, 12 and the electrode members 13, 14 is decreased by the active metal-containing bonding material, so that the internal resistance of the thermoelectric conversion module 10 as a whole can be decreased. In addition, the thermal resistance between the thermoelectric elements 11, 12 and the electrode members 13, 14 is also lowered, so that the heat (temperature difference) for obtaining power can be conducted efficiently to the thermoelectric elements 11, 12. Thus, the thermoelectric conversion efficiency of the thermoelectric conversion module 10 can be improved.

As described above, the use of the bonding material containing at least one active metal selected from Ti, Zr, Hf, Ta, V and Nb for the bonding parts 17 for bonding the thermoelectric elements 11, 12 made of the half-Heusler material to the electrode members 13, 14 not only provides a mechanically firm bonding structure, but also can realize a bonding structure having low electrical contact resistance and thermal resistance. Thus, the module performance such as mechanical strength, reliability, thermoelectric conversion efficiency and the like of the thermoelectric conversion module 10 using the thermoelectric elements 11, 12 made of the half-Heusler material can be improved.

For the bonding parts 17 for bonding the thermoelectric elements 11, 12 and the electrode members 13, 14, a bonding material which contains at least one selected from Ag, Cu and Ni as a main component and at least one of active metal selected from Ti, Zr, Hf, Ta, V and Nb in a range of 1% by mass or more and 10% by mass or less is used as described above. If the content of the active metal is less than 1% by mass, the enhancing effect of wettability to the half-Heusler material and the improving effect of the bonded state cannot be obtained sufficiently. Meanwhile, if the content of the active metal exceeds 10% by mass, the original property (property as the brazing material) as the bonding material degrades, and the reliability in terms of the thermal stress lowers. The content of the active metal in the bonding material is more preferably in a range of 1 to 6% by mass.

For the main material of the bonding material compounding the active metal, a brazing material mainly containing at least one selected from Ag, Cu and Ni is used. Use of the bonding material having the brazing material as the main material enables to enhance the reliability of the bonding parts 17 under a high temperature. The brazing material applied to the bonding parts 17 may be any if it contains mainly at least one selected from Ag, Cu and Ni, and it is particularly desirable to use an Ag-Cu alloy (Ag-Cu brazing material) in view of a bonding temperature (melting temperature) and the like.

In addition, the active metal-containing bonding material may contain Sn, In, Zn, Cd, C or the like as a third component. Addition of the third component can lower the bonding temperature. The content of the third component is appropriately selected from a range of 40% by mass or less. If the content of the third component exceeds 40% by mass, the component amount of the brazing material which becomes the main component of the active metal-containing bonding material decreases relatively, so that there is a possibility that the bonding strength is degraded. The content of the third component is desirably 30% by mass or less. The lower limit value of the content of the third component is not particularly limited but determined from a range of effective amount depending on the individual elements. For example, 10% by mass or more is practically effective.

Bonding of the thermoelectric elements 11, 12 and the electrode members 13, 14 by the active metal-containing bonding material is performed by arranging the active metal-containing bonding material on the electrode members 13, 14, additionally arranging the thermoelectric elements 11, 12 on it, and thermally treating them in vacuum or in an inert atmosphere. Use of the active metal-containing bonding material allows determining the ratio of the pores present in the bonded interface and the like to be 10% or less as described above. In addition, it is desirable to apply a pressure of 20 kPa or more when heating in order to decrease the amount of the pores present in the bonded interface and the like. Thus, the ratio of the pores present in the bonded interface and the like can be determined to be, for example, 5% or less.

In addition, in order to further decrease the amount of the pores present in the bonded interface and the like, the pressure applied to bond the thermoelectric elements 11, 12 and the electrode members 13, 14 is preferably 40 kPa or more. In addition, it is also effective to perform the thermal treatment for bonding in a vacuum atmosphere of $7 \times 10^{-1}$ Pa or less or an Ar gas atmosphere, to smoothen the bonding surfaces of the thermoelectric elements 11, 12, and to determine the thickness of the bonding parts 17 to fall in a range of 10 to 30 $\mu$m. Thus, the ratio of the pores present in the bonded interface and the like can be determined to be, for example, 3% or less.

The above-described active metal-containing bonding material is not limited to the bonding of the thermoelectric elements 11, 12 and the electrode members 13, 14, but also effective as a bonding material for bonding the electrode members 13, 14 with the upper and lower insulating heat-conducting plates 15, 16. In other words, the first and second electrode members 13, 14 each are bonded to the upper and lower insulating heat-conducting plates 15, 16 via bonding parts 18. It is also desirable to apply the above-described active metal-containing bonding material to the bonding parts 18. Thus, the bonding strength and bonding reliability between the electrode members 13, 14 and the insulating heat-conducting plates 15, 16 can be enhanced, and the thermal resistance can be decreased. They also contribute to the improvement of the module performance of the thermoelectric conversion module 10.

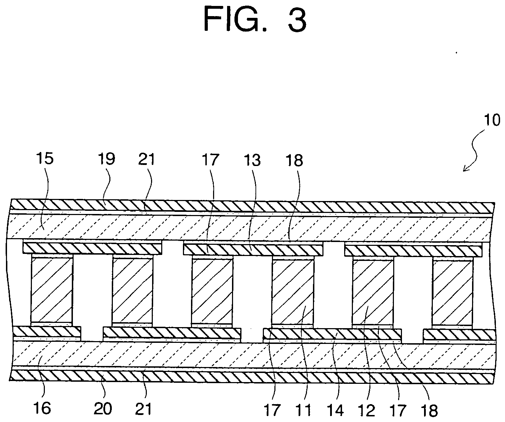

The thermoelectric conversion module 10 can be configured of the above-described individual elements. For example, metal plates 19, 20 of the same material as that of the electrode members 13, 14 may be also arranged on the outsides of the upper and lower insulating heat-conducting plates 15, 16 as shown in Fig. 3. These metal plates 19, 20 are bonded to the insulating heat-conducting plates 15, 16 via bonding parts 21 to which the active metal-containing bonding material is applied in the same manner as the bonding of the electrode members 13, 14 and the insulating heat-conducting plates 15, 16. Thus, bonding of the metal plates (the electrode members 13, 14 and the metal plates 19, 20), which are made of the same material as that of the insulating heat-conducting plates 15, 16, to the both surfaces of the insulating heat-conducting plates 15, 16 can suppress the occurrence of cracks due to a thermal expansion difference between the insulating heat-conducting plates 15, 16 and the electrode members 13, 14.

The thermoelectric conversion module 10 shown in Fig. 1 or Fig. 3 has the upper insulating heat-conducting plate 15 disposed on a low temperature side (L) and the lower insulating heat-conducting plate 16 disposed on a high temperature side (H) so as to have a temperature difference between, for example, the upper and lower insulating heat-conducting plates 15, 16. A potential difference is produced between the first electrodemember 13 and the second electrode member 14 because of the temperature difference, and power can be derived by connecting a load to a terminal end of the electrode. Thus, the thermoelectric conversion module 10 is effectively used as a power generating module. At this time, the thermoelectric elements 11, 12 made of the half-Heusler material can be used at a high temperature (for example, 300°C or higher) and has high thermoelectric conversion performance with the internal resistance or thermal resistance of the module as a whole lowered, so that it is possible to realize a highly efficient power generating system using a high-temperature heat source.

The thermoelectric conversion module 10 is not limited to use for power generating that heat is converted into power but can also be used for heating or cooling use that electricity is converted into heat. Specifically, when DC current is flown to the p-type thermoelectric elements 11 and the n-type thermoelectric elements 12 which are connected in series, heat is radiated on a part of one of the insulating heat-conducting plates, while heat is absorbed on a part of the other insulating heat-conducting plate. Therefore, a subject to be treated can be disposed on the heat radiation side insulating heat-conducting plate to heat the subject to be treated. Otherwise, the subject to be treated can be disposed on the heat absorption side insulating heat-conducting plates to cool the subject to be treated by removing heat from it. For example, a semiconductor manufacturing device controls the temperature of semiconductor wafers, so that the thermoelectric conversion module 10 can be applied to such temperature control.

An embodiment of the heat exchanger of the invention will be described. The heat exchanger according to the embodiment of the invention is provided with the thermoelectric conversion module 10 according to the above-described embodiment. The heat exchanger has a structure that a heating surface (heat-absorbing surface) is basically disposed on one side of the thermoelectric conversion module 10, and a cooling surface (heat radiation surface) is disposed on its opposite side. For example, the heat-absorbing surface is provided with a passage where a high-temperature medium from the heat source passes, and the heat radiation surface on the opposite side is provided with a passage where a low-temperature heat medium such as cooling water, air or the like passes. A fin, a baffle or the like may be disposed within and outside of the passages where the heat medium passes. A heat radiation plate, a fin, a heat-absorbing plate or the like may be used instead of the water passage or the gas passage.

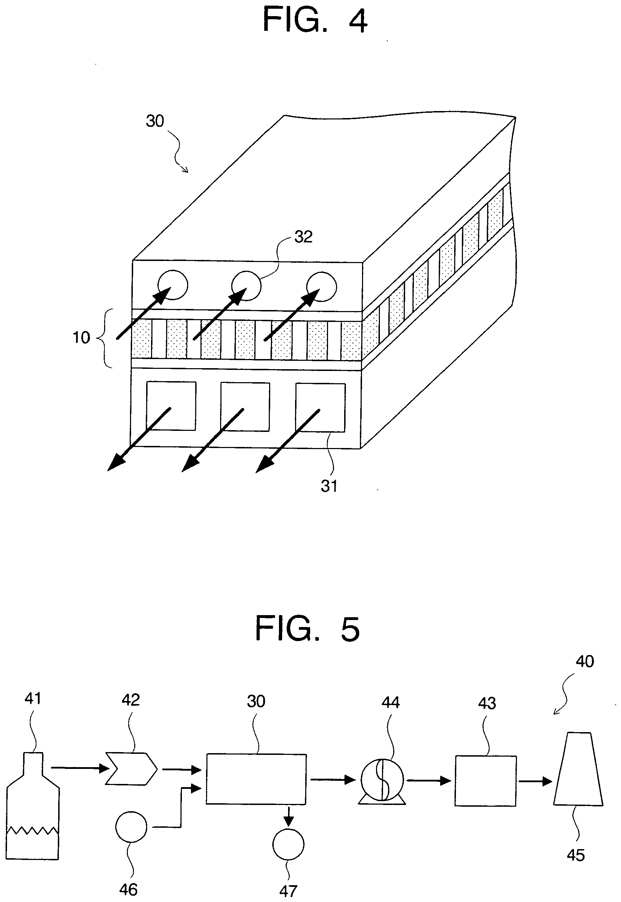

Fig. 4 is a perspective view showing a schematic structure of the heat exchanger according to an embodiment of the invention. A heat exchanger 30 shown in Fig. 4 has gas passages 31 arranged in contact with one side surface of the thermoelectric conversion module 10, and water passages 32 arranged in contact with the opposite side surface. For example, high-temperature waste gas is introduced from a waste incinerator into the gas passages 31. Meanwhile, cooling water is introduced into the water passages 32. One side surface of the thermoelectric conversion module 10 is made to be a high temperature side by the high-temperature waste gas passing through the gas passages 31, and the other side surface is made to be a low temperature side by the cooling water passing through the water passages 32.

Thus, the generation of the temperature difference between the both ends of the thermoelectric conversion module 10 enables to derive power from the thermoelectric conversion module 10 configuring the heat exchanger 30. As to the heat-absorbing surface, not only the high-temperature waste gas from a combustion furnace, but also, for example, exhaust gas from an automobile engine, the inner water pipe of a boiler or the like can be applied, and a combustion portion itself for burning various types of fuels may be applied.

An embodiment of the thermoelectric power generating apparatus of the invention will be described. The thermoelectric power generating apparatus according to the embodiment of the invention is provided with the heat exchanger 30 of the above-described embodiment. The thermoelectric power generating apparatus includes basically a heat supply portion which supplies the heat exchanger 30 with heat for power generation and converts the heat supplied by the heat supply portion into power by the thermoelectric conversion module 10 of the heat exchanger 30 to generate power.

Fig. 5 shows a structure of an exhaust heat utilization power generating system using exhaust heat of a waste incinerator as an example of the thermoelectric power generating apparatus applying the heat exchanger 30 according to an embodiment of the invention. An exhaust heat utilization power generating system 40 shown in Fig. 5 has a structure that the heat exchanger 30 of the above-described embodiment is added to a waste incineration system having an incinerator 41 for incinerating combustible garbage, an air blowing fan 44 for blowing air to an exhaust smoke treatment equipment 43 by absorbing waste gas 42, and a chimney 45 for diffusing the waste gas 42 into the atmosphere. Incineration of waste in the incinerator 41 produces the high-temperature waste gas 42. The waste gas 42 is introduced into the heat exchanger 30, and cooling water 46 is introduced, so that a temperature difference is produced between the both ends of thermoelectric conversion module 10 within the heat exchanger 30, and power is derived. The cooling water 46 is discharged as hot water 47.

The thermoelectric power generating system to which the heat exchanger of the invention is applied is not limited to the waste incineration system but can be applied to plants having various types of incinerators, heating furnaces, melting furnaces and the like. And, the exhaust pipe of an automobile engine can be used as a gas passage for high-temperature waste gas, and the inner water pipe of the boiler of a brackish water thermal power generating plant can also be used as heat supply device. For example, the heat exchanger of the invention is disposed on the surface of the inner water pipe or water pipe fin of the boiler of the brackish water thermal power generating plant, the high temperature side is determined to be the inside of the boiler, and the low temperature side is determined to be the side of the water pipe, so that power and steam to be sent to the steam turbine can be obtained at the same time, and the efficiency of the brackish water thermal power generating plant can be improved. In addition, the device which supplies the heat exchanger with heat may be a combustion portion itself, such as the combustion portion of a combustion heating system, for burning various types of fuels.

Specific examples of the invention and their evaluated results will be described below.

Example 1

The thermoelectric conversion module shown in Fig. 1 was produced by the following procedure. First, a thermoelectric element production example will be described.

(n-Type thermoelectric element)

First, Ti, Zr, Ni and Sn were weighed and mixed so to have a $(Ti_{0.5}Zr_{0.5})$ NiSn composition. The mixture raw material was charged into a copper hearth being cooled with water within an arc furnace and arc melted in a decompressed Ar atmosphere. The alloy was pulverized with a mortar and subjected to pressure sintering under conditions of an Ar atmosphere of 80 MPa at 1200°C for one hour to obtain a disk-shaped sintered body having a diameter of 20 mm. The obtained sintered body was cut into a desired shape to obtain the thermoelectric elements.

(p-Type thermoelectric element)

Ti, Zr, Fe, Co and Sb were weighed and mixed to obtain a $(Ti_{0.5}Zr_{0.5})(Fe_{0.2}Co_{0.8})Sb$ composition. The mixture raw material was charged into a copper hearth being cooled with water within an arc furnace and arc melted in a decompressed Ar atmosphere. The alloy was pulverized with a mortar and subjected to pressure sintering under conditions of an Ar atmosphere of 80 MPa at 1200°C for one hour to obtain a disk-shaped sintered body having a diameter of 20 mm. The obtained sintered body was cut into a desired shape to obtain the thermoelectric elements.

The above-described p-type thermoelectric elements and n-type thermoelectric elements were used to produce a thermoelectric conversion module as follows.

(Thermoelectric conversion module)

In this Example, an $Si_3N_4$ ceramics plate (thermal conductivity of 80 W/m•K, three point bending strength of 700 MPa) was used as an insulating heat-conducting plate, and a Cu plate was used as the electrode material to produce the thermoelectric conversion module. First, Ti-containing Ag-Cu brazing material having a composition ratio (mass ratio) of Ag:Cu:Sn:Ti=61.9:24.1:10:4 was prepared, and its paste was screen-printed on the $Si_3N_4$ plate. It was dried, Cu electrode plates were arranged in four vertically and eight horizontally on the paste layer to arrange a total of 32 Cu electrode plates on the $Si_3N_4$ plate. Then, a heat treatment was performed in a vacuum of 0.01 Pa or less at 800°C for 20 minutes to bond the $Si_3N_4$ plate and the Cu electrode plates. The above-described brazing material was used to bond the Cu plates to the entire surface on the opposite side of the Cu electrode plate-arranged $Si_3N_4$ plate.

The above-described paste type Ti-containing Ag-Cu brazing material was then screen-printed on the Cu electrode plates and dried to obtain a substrate for a thermoelectric module. The thermoelectric module substrate was used in two and laminated with a thermoelectric element interposed between them. The thermoelectric element had the p-type and n-type thermoelectric elements arranged alternately on the brazing material printed on the Cu electrode plate in four pairs vertically and eight columns horizontally, to have a square shape made of a total of 32 pairs. The laminated body was placed in an electric furnace and subjected to a heat treatment in a vacuum of 0.1 Pa at 800°C for 20 minutes to bond the individual thermoelectric elements and the Cu electrode plates. After cooling, the laminated body was removed from the furnace to find that all the thermoelectric elements were bonded with the Cu electrode plates with sufficient strength.

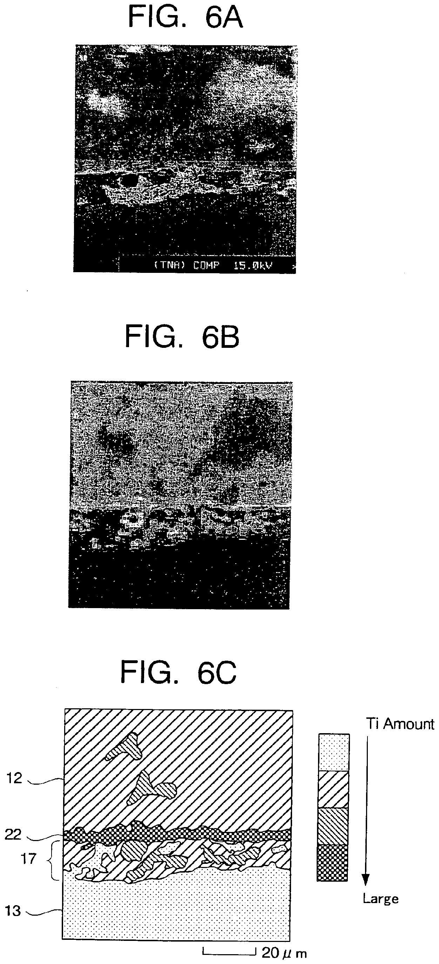

Fig. 6A, Fig. 6B and Fig. 6C show states of bonded interfaces between the n-type thermoelectric element 12 and the Cu electrode material 13. Fig. 6A shows an SEM observation image (SEM secondary electron image), Fig. 6B is an element mapping view of Ti of the same portion according to EPMA, and Fig. 6C is an explanatory view of Fig. 6B, showing the Ti concentration in four gradations in order of dark to light. It is apparent from Fig. 6C that a layer having an especially high Ti concentration is formed in the bonded interface.

This Ti results from segregation of Ti in the active metal-containing bonding material 17, and this layer agrees with a portion having a high Ni concentration or Sn concentration. Ni and Sn in the thermoelectric element 12 react with Ti in the bonding material to form an alloy layer 22 having a Ti-Ni or Ti-Sn composition is formed, and the interface has a complex structure. It is presumed that firm bonding is made because of the presence of the alloy layer 22 and the complex structure of the bonded interface. It was confirmed that the alloy layer having a Ti-Co composition or Ti-Sb composition was formed in the bonded interfaces between the p-type thermoelectric elements 11 and the Cu electrode materials 13.

The thermoelectric conversion module produced as described above was measured for its thermoelectric properties under a matched load condition by determining a high temperature side to be 500°C and a low temperature side to be 50°C and connecting the module's inside resistance and a load having the same resistance value as a load. As a result, the generated voltage was 3.0 V and power was 7.0 W. Under the same conditions, a 1000-hour continuous operation was performed, the temperature was resumed to room temperature, and the operation was performed again under the same conditions. This procedure was repeated ten times, and when a total operation time became 10000 hours, the thermoelectric properties were measured. It was confirmed that the initial performance was maintained. In addition, the bonding parts between the thermoelectric elements and the Cu electrode plates were maintained in a good state, and the bonding parts and the thermoelectric elements were found having no breakage, deformation or the like.

Table 1 shows the combinations of the thermoelectric elements, electrodes and bonding materials and the evaluated results of individual modules. The evaluated results in Table 1 show the number of times that peeling, a crack or the like was not caused on the bonding parts by repeating an operation that the thermoelectric conversion module was determined to have a high temperature side maintained at 500°C and a low temperature side maintained at 50°C for tenminutes and returned to room temperature. It was determined that a denotes that the number of times was 30 or more, b denotes that the number of times was one to less than 30, c denotes that the number of times was zero, and d denotes that peeling occurred before the temperature was increased to 500°C. Examples 2 to 9

The same thermoelectric conversion modules as that of Example 1 were produced except that the combinations of the thermoelectric elements, electrodes and bonding materials were changed. The thermoelectric conversion modules were evaluated for their performance in the same manner as in Example 1. Table 1 shows the combinations of the thermoelectric elements, electrodes and bonding materials and the evaluated results of individual modules. In any of the combinations according to Examples 2 to 9, the bonding parts were free from peeling or a crack even after repeating an operation of holding at 500°C for ten minutes for 30 times or more.

Comparative Examples 1 to 6

The same thermoelectric conversion modules as that of Example 1 were produced except that the combinations of the thermoelectric elements, electrodes and bonding materials were changed. The thermoelectric conversion modules of Comparative Examples were evaluated for their performance in the same manner as in Example 1. Table 1 shows the combinations of the thermoelectric elements, electrodes and bonding materials according to Comparative Examples and the evaluated results of individual modules.

[Table 1]

| | | Thermoelectric element composition | | Bonding material | Electrode material | Evaluation |
|---|---|---|---|---|---|---|
| E 1 | n type | $(Ti_{0.5}Zr_{0.5})_{0.8}Nb_{0.2}NiSn$ | | Ti-containing Au-Cu brazing material | Cu | a |
| | p type | $(Ti_{0.5}Zr_{0.5})(Fe_{0.2}Co_{0.8})Sb$ | | | | |
| E 2 | n type | $(Ti_{0.5}Zr_{0.5})_{0.8}Nb_{0.2}NiSn$ | | Ti-containing Au-Cu brazing material | Ag | a |
| | p type | $(Ti_{0.5}Zr_{0.5})(Fe_{0.2}Co_{0.8})Sb$ | | | | |
| E 3 | n type | $(Ti_{0.5}Zr_{0.5})_{0.8}Nb_{0.2}NiSn$ | | Ti-containing Au-Cu brazing material | SUS430 | a |
| | p type | $(Ti_{0.5}Zr_{0.5})(Fe_{0.2}Co_{0.8})Sb$ | | | | |
| E 4 | n type | $(Ti_{0.5}Zr_{0.5})Ni_{1.8}Sn$ | | Ti-containing Au-Cu brazing material | Cu | a |
| | p type | $(Ti_{0.5}Hf_{0.5})Co_{1.8}Sb$ | | | | |
| E 5 | n type | $(Ti_{0.3}Zr_{0.3}Hf_{0.35})NiSn$ | | Ti-containing Au-Cu brazing material | Cu | a |
| | p type | ErNiSb | | | | |
| E 6 | n type | $Fe_{0.975}Co_{0.025}VSb$ | | Ti-containing Au-Cu brazing material | Cu | a |
| | p type | $Fe_{0.85}Ti_{0.15}Sb$ | | | | |
| E 7 | n type | $Zr_{1.2}NiSn$ | | Ti-containing Au-Cu brazing material | Cu | a |
| | p type | $Er_{0.25}Dy_{0.75}PdSb_{1.05}$ | | | | |
| E 8 | n type | $(Ti_{0.5}Zr_{0.5})(Co_{0.99}Ni_{0.01})Sb$ | | Ti-containing Au-Cu brazing material | Cu | a |
| | p type | $HoPdSb_{1.05}$ | | | | |
| E 9 | n type | $(Zr_{0.5}Hf_{0.5})NiSn_{1.7}$ | | Ti-containing Au-Cu brazing material | Cu | a |
| | p type | LaPdBi | | | | |
| CE 1 | n type | $(Ti_{0.5}Zr_{0.5})_{0.8}Nb_{0.2}NiSn$ | | Ag brazing | Cu | d |
| | p type | $(Ti_{0.5}Zr_{0.5})(Fe_{0.2}Co_{0.8})Sb$ | | | | |
| CE 2 | n type | $(Ti_{0.5}Zr_{0.5})_{0.8}Nb_{0.2}NiSn$ | | Ag brazing + flux | Cu | b |
| | p type | $(Ti_{0.5}Zr_{0.5})(Fe_{0.2}Co_{0.8})Sb$ | | | | |
| CE 3 | n type | $(Ti_{0.5}Zr_{0.5})_{0.8}Nb_{0.2}NiSn$ | | (Diffusion bonding) | Ag | c |
| | p type | $(Ti_{0.5}Zr_{0.5})(Fe_{0.2}Co_{0.8})Sb$ | | | | |
| CE 4 | n type | $(Ti_{0.5}Zr_{0.5})_{0.8}Nb_{0.2}NiSn$ | | Ag brazing | Cu | d |
| | p type | $(Ti_{0.5}Zr_{0.5})(Fe_{0.2}Co_{0.8})Sb$ | | | | |

(continued)

|  | | Thermoelectric element composition | Bonding material | Electrode material | Evaluation |
|---|---|---|---|---|---|
| CE 5 | n type | $(Ti_{0.5}Zr_{0.5})_{0.8}Nb_{0.2}NiSn$ | Ag brazing + flux | SUS430 | d |
|  | p type | $(Ti_{0.5}Zr_{0.5})(Fe_{0.2}Co_{0.8})Sb$ | | | |
| CE 6 | n type | $(Ti_{0.5}Zr_{0.5})_{0.8}Nb_{0.2}NiSn$ | (Diffusion bonding + Al foil) | SUS430 | c |
|  | p type | $(Ti_{0.5}Zr_{0.5})(Fe_{0.2}Co_{0.8})Sb$ | | | |

E1 to E9 = Example 1 to Example 9; CE 1 to CE 6 = Comparative Example 1 to Comparative Example 6

Comparative Example 1 used Ag brazing (BAg-8 foil having a thickness of 20 $\mu$m) instead of the bonding material used in Example 1. The Ag brazing had very poor wettability to the thermoelectric element made of an MgAgAs type intermetallic compound, and the module had a bonding strength of a level that it was peeled with a hand. In Comparative Example 2, in order to improve the wettability, boric acid dissolved in water was coated as flux onto the surfaces of the thermoelectric elements and dried, the BAg-8 foil was used, and bonding was performed under the same conditions as in Example 1. An operation that the thermoelectric conversion module was maintained at 500°C for ten minutes and lowered to room temperature was repeated two times. As a result, the electrodes and the thermoelectric elements were peeled.

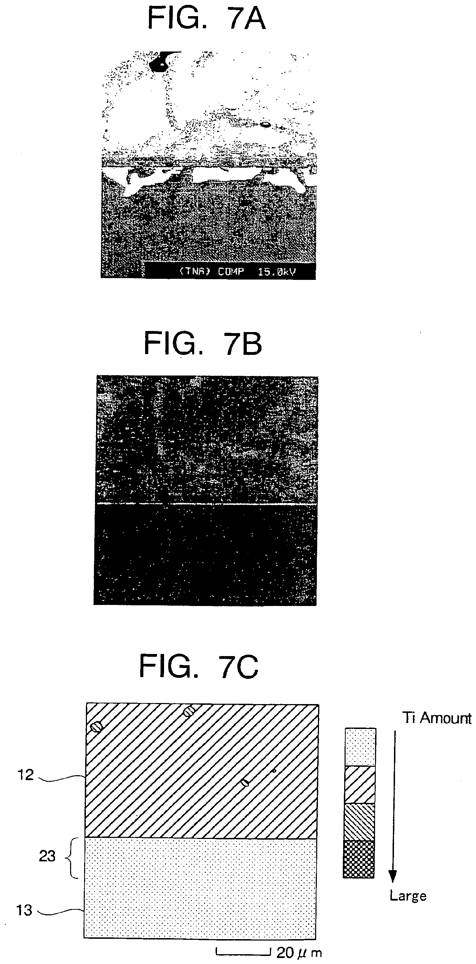

Fig. 7A, Fig. 7B and Fig. 7C show states of bonded interfaces between the n-type thermoelectric element 12 and the Cu electrode material 13 of Comparative Example 1 using Ag brazing as a bonding material. Fig. 7A is an SEM observation image, Fig. 7B is a Ti element mapping view on the same portion according to EPMA, and Fig. 7C is an explanatory view of Fig. 7B, showing the Ti concentration in four gradations in order of dark to light. The Ti segregation layer and the like observed in Fig. 6 were not observed in Comparative Example 1, and the bonded interface was flat. Reaction did not occur between the thermoelectric element 12 and the bonding material 23, and an alloy layer was not formed. Thus, it was found that the bonding strength between the thermoelectric elements 11, 12 and the Cu electrode materials 13 of the module not having an alloy layer formed on the bonded interface was low, and firm bonding was not obtained by the bonding material not containing an active metal.

In Comparative Example 3, an Ag plate having a thickness of 200 $\mu$m was used as the electrode material, and the electrode material and the thermoelectric element were directly bonded under a load of 0.5 MPa at 800°C. But, when a high temperature side of the bonded module was raised to 500°C and then lowered to room temperature, the bonding parts were peeled. An Ag plate was used as the electrode material in Comparative Example 4 and an SUS430 plate was used as the electrode material in Comparative Example 5, and bonding was performed using a BAg-8 foil as abondingmaterial. But, bonding was not achieved well, and the bonding strength was of a level that peeling could be made with a hand in both the comparative examples. In Comparative Example 6, the SUS430 plate was used as the electrode material, and diffusion bonding was tried with an Al foil having a thickness of 0.25 mm interposed at 600°C (load of 2 5 MPa). But, when the high temperature side of the module bonded in the same manner as in Comparative Example 3 was raised to 500°C and then lowered to room temperature, the bonding parts were peeled.

In comparison with the respective Comparative Examples, when the bonding material containing at least one selected from Ti, Zr, Hf, Ta, V and Nb was used as the active metal as in Example 1, the electrode material and the thermoelectric element can be adhered firmly without performing a special pretreatment. By containing the above-described active metal, wettability to the thermoelectric element made of the half-Heusler material is improved significantly, and an alloy layer of the active metal and the constituent element of the thermoelectric element is formed in the bonded interface. Thus, it is seen that the thermoelectric conversion modules of the respective Examples have the bonding parts which are excellent in heat cycle property and are excellent in practical utility.

Examples 10 to 34 and Comparative Examples 7 to 9

Thermoelectric conversion modules were produced in the same manner as in Example 1 except that the bonding materials having the compositions shown in Table 2 and Table 3 were used and an $Si_3N_4$ plate having a thickness of 2 mm was used as the insulating heat-conducting plate. Thermoelectric modules were produced in the same manner as in Example 2 except that when the bondingmaterials having the compositions shown in Table 3 were used, the bonding temperature was changed to 1030°C and the electrode material was changed to SUS430. Output and module resistance were measured from I-V properties of the respective thermoelectric conversion modules obtained above, and the resistance values of the bonded interfaces were determined. The resistance values of the bonded interfaces were determined from an equation [(module resistance)-(total sum of 64-device resistance values)].

The device resistance value used was a value obtained by measuring previously a thermoelectric element only according to a DC four-terminal method. In addition, four bending test pieces of 3 mm in thickness, 4 mm in width and 40 mm in length each were cut for the p-type and n-type thermoelectric elements with the bonded surfaces of the device and electrodes at the center from the bonding parts of the device/electrode/insulating heat-conducting plates of the individual modules. The individual test pieces were measured for a bonding strength according to a four-point bending test method. The measured results are shown in Table 4. Table 4 also shows the measured results of the respective thermoelectric modules of Examples 1 to 9.

[Table 2]

|  | Bonding material composition (% by mass) | | | | | | | | | | | | |
|---|---|---|---|---|---|---|---|---|---|---|---|---|---|
|  | Ag | Cu | Sn | In | Zn | Cd | Ti | Zr | Hf | V | Nb | Ta | C |
| E1 | 61.9 | 24.1 | 10.0 | - | - | - | 4.0 | - | - | - | - | - | |
| E2 | 70.6 | 27.4 | - | - | - | - | 2.0 | - | - | - | - | - | |
| E3 | 70.6 | 27.4 | - | - | - | - | - | 2.0 | - | - | - | - | |
| E4 | 27.4 | 70.6 | - | - | - | - | - | - | - | - | 2.0 | - | |
| E5 | 27.7 | 71.3 | - | - | - | - | 1.0 | - | - | - | - | - | |
| E6 | 34.3 | 63.7 | - | - | - | - | 2.0 | - | - | - | - | - | |
| E7 | 69.6 | 26.4 | - | - | - | - | 4.0 | - | - | - | - | - | |
| E8 | 67.7 | 26.3 | - | - | - | - | 6.0 | - | - | - | - | - | |
| E9 | 69.6 | 26.4 | - | - | - | - | - | 4.0 | - | - | - | - | |
| E10 | 26.9 | 69.1 | - | - | - | - | - | - | - | - | 4.0 | - | |
| E11 | 59.0 | 23.0 | - | 14.0 | - | - | - | - | - | 4.0 | - | - | |
| E12 | 46.8 | 18.2 | - | - | 26.0 | - | 4.0 | - | - | - | - | 5.0 | |
| E13 | 59.0 | 23.0 | - | 14.0 | - | - | 4.0 | - | - | - | - | - | |
| E14 | 59.0 | 23.0 | - | 14.0 | - | - | - | 4.0 | - | - | - | - | |
| E15 | 59.0 | 23.0 | - | 14.0 | - | - | - | - | 4.0 | - | - | - | |
| E16 | 55.0 | 22.0 | - | 14.0 | - | - | 4.0 | - | - | - | 5.0 | - | |
| E17 | 41.8 | 16.2 | - | - | 18.0 | 20.0 | 4.0 | - | - | - | - | - | |
| E18 | 58.0 | 28.0 | 5.0 | 5.0 | - | - | 4.0 | - | - | - | - | - | |
| E19 | 55.0 | 28.0 | 5.0 | 5.0 | - | - | 5.0 | - | 2.0 | - | - | - | |
| E20 | 58.0 | 28.0 | 5.0 | 5.0 | - | - | 3.0 | 1.0 | - | - | - | - | - |
| E21 | 58.0 | 23.0 | - | 14.0 | - | - | 4.0 | - | - | - | - | - | 1.0 |
| E22 | 57.0 | 23.0 | - | 14.0 | - | - | - | - | - | - | 5.0 | - | 1.0 |
| E23 | 61.0 | 24.0 | - | 10.0 | - | - | 4.0 | - | - | - | - | - | 1.0 |
| E24 | 58.0 | 23.0 | - | 14.0 | - | - | - | 4.0 | - | - | - | - | 1.0 |
| E25 | 58.5 | 23.0 | - | 14.0 | - | - | - | - | 4.0 | - | - | - | 0.5 |
| E26 | 58.0 | 22.0 | - | 14.0 | - | - | 4.0 | - | - | - | - | - | 2.0 |
| E27 | 55.0 | 22.0 | - | 14.0 | - | - | 4.0 | - | - | - | - | - | 5.0 |
| E28 | 53.0 | 22.0 | - | - | 20.0 | - | 4.0 | - | - | - | - | - | 1.0 |
| E29 | 61.0 | 24.0 | 10.0 | - | - | - | 4.0 | - | - | - | - | - | 1.0 |
| E30 | 42.0 | 17.0 | - | - | 18.0 | 18.0 | 4.0 | - | - | - | - | - | 1.0 |
| CE7 | 72.0 | 28.0 | - | - | - | - | - | - | - | - | - | - | - |
| CE8 | 35.0 | 26.0 | - | 21.0 | 18.0 | - | - | - | - | - | - | - | - |

(continued)

| | Bonding material composition (% by mass) | | | | | | | | | | | | |
|---|---|---|---|---|---|---|---|---|---|---|---|---|---|
| | Ag | Cu | Sn | In | Zn | Cd | Ti | Zr | Hf | V | Nb | Ta | C |
| CE9 | 56.0 | 22.0 | 5.0 | - | 17.0 | - | - | - | - | - | - | - | - |
| E1 to E30= Example 1 to Example 30; CE7 to CE9= Comparative Example 7 to Comparative Example 9 | | | | | | | | | | | | | |

[Table 3]

| | Bonding material composition (% by mass) | | | | | | | | | |
|---|---|---|---|---|---|---|---|---|---|---|
| | Ni | Cr | B | Si | Fe | C | P | Yi | Zr | Other |
| Example 31 | 78.1 | 6.7 | 2.95 | 4.3 | 2.8 | 0.05 | 0.02 | 5.0 | - | Balance |
| Example 32 | 71.5 | 13.3 | 0.01 | 0.1 | 0.15 | 0.08 | 9.5 | 5.0 | - | Balance |
| Example 33 | 78.1 | 6.7 | 2.95 | 4.3 | 2.8 | 0.05 | 0.02 | - | 4.0 | Balance |
| Example 34 | 71.5 | 13.3 | 0.01 | 0.1 | 0.15 | 0.08 | 9.5 | - | 4.0 | Balance |

[Table 4]

| | p-type material bonding strength (MPa) | n-type material bonding strength (MPa) | Bonding interface resistance($\Omega$) | Output (W) |
|---|---|---|---|---|
| Example 1 | 132.6 | 145.9 | 0.14 | 7.0 |
| Example 2 | 107.1 | 118.9 | 0.18 | 6.8 |
| Example 3 | 86.7 | 95.4 | 0.22 | 6.6 |
| Example 4 | 91.8 | 90.4 | 0.21 | 6.7 |
| Example 5 | 87.7 | 96.5 | 0.24 | 6.4 |
| Example 6 | 102.0 | 112.5 | 0.20 | 6.7 |
| Example 7 | 122.4 | 134.6 | 0.15 | 6.9 |
| Example 8 | 127.5 | 138.8 | 0.17 | 6.8 |
| Example 9 | 102.0 | 97.4 | 0.19 | 6.7 |
| Example 10 | 112.2 | 104.3 | 0.16 | 6.9 |
| Example 11 | 112.8 | 99.7 | 0.17 | 6.9 |
| Example 12 | 102.0 | 100.0 | 0.20 | 6.7 |
| Example 13 | 102.0 | 112.2 | 0.18 | 6.8 |
| Example 14 | 122.4 | 134.6 | 0.15 | 6.9 |
| Example 15 | 102.0 | 119.3 | 0.21 | 6.7 |
| Example 16 | 112.2 | 131.3 | 0.17 | 6.9 |
| Example 17 | 102.0 | 119.3 | 0.18 | 6.8 |
| Example 18 | 122.4 | 143.2 | 0.18 | 6.8 |
| Example 19 | 114.6 | 103.3 | 0.16 | 6.9 |
| Example 20 | 112.4 | 131.1 | 0.17 | 6.9 |
| Example 21 | 127.5 | 149.2 | 0.14 | 7.1 |
| Example 22 | 122.4 | 143.2 | 0.15 | 6.9 |

(continued)

|  | p-type material bonding strength (MPa) | n-type material bonding strength (MPa) | Bonding interface resistance($\Omega$) | Output (W) |
| --- | --- | --- | --- | --- |
| Example 23 | 137.7 | 161.1 | 0.13 | 7.0 |
| Example 24 | 127.5 | 140.3 | 0.15 | 7.1 |
| Example 25 | 117.3 | 100.5 | 0.16 | 6.9 |
| Example 26 | 107.1 | 110.3 | 0.18 | 6.8 |
| Example 27 | 91.8 | 94.6 | 0.22 | 6.6 |
| Example 28 | 96.9 | 99.8 | 0.19 | 6.7 |
| Example 29 | 146.9 | 161.5 | 0.15 | 6.9 |
| Example 30 | 127.5 | 140.3 | 0.19 | 6.7 |
| Example 31 | 94.8 | 104.1 | 0.20 | 6.4 |
| Example 32 | 92.3 | 101.7 | 0.19 | 6.7 |
| Example 33 | 97.3 | 107.0 | 0.18 | 6.6 |
| Example 34 | 91.1 | 98.9 | 0.21 | 6.1 |
| Comparative Example 7 | (not bonded) | (not bonded) | - | - |
| Comparative Example 8 | (not bonded) | (not bonded) | - | - |
| Comparative Example 9 | (not bonded) | (not bonded) | - | - |

It is apparent from Table 4 that when the bonding material containing the active metal is used, the thermoelectric elements and the electrode members are bonded firmly, the contact resistance between them is decreased, and high output can be obtained. Meanwhile, the bonding material not containing the active metal was used in Comparative Examples 7 to 9, and it is seen that the electrodes and the thermoelectric elements cannot be bonded.

Example 35

The n-type thermoelectric element having a $(Ti_{0.3}Zr_{0.35}Hf_{0.35})NiSn$ composition and the p-type thermoelectric element having a $(Ti_{0.3}Zr_{0.35}Hf_{0.35})CoSb_{0.85}Sn_{0.15}$ composition were prepared. The bonded surfaces of the individual thermoelectric elements had surface roughness Ra of 4 $\mu$m. They were used to produce a thermoelectric conversion module as follows. First, a paste of a Ti-containing Ag-Cu brazing material having a composition ratio (mass ratio) of Ag:Cu:Sn:Ti:C=60.5:23.5:10.0:4.0:2.0 was screen-printed on an $Si_3N_4$ plate having a thickness of 0.7 mm. After drying it, Cu electrode plates were arranged in six vertically and in 12 horizontally on the paste layer, and a total of 50 Cu electrode plates were arranged on the $Si_3N_4$ plate. Then, a heat treatment was performed in a vacuum of 0.8 Pa or less at 800°C for 20 minutes to bond the $Si_3N_4$ plate and the Cu electrode plates. The above-described brazing material was used to bond the Cu plates to the entire surface opposite to the surface of the $Si_3N_4$ plate on which the Cu electrode plates were arranged.

Then, the above-described paste of the Ti-containing Ag-Cu brazing material was screen-printed on the Cu electrode plates, and the dried products were used as substrates for the thermoelectric modules. Two of the thermoelectric module substrates were used and laminated with a thermoelectric element interposed between them. The thermoelectric elements were arranged in five vertically and ten horizontally to form a square form by 50 of them by having the p-type and n-type thermoelectric elements alternately arranged on the brazing material printed on the Cu electrode plates. A weight of 4.5 kg was placed on the laminated body to apply a pressure of 50 kPa to the bonded surfaces between the Cu electrode plates and the thermoelectric elements, and the laminated body was placed in the electric furnace. And, a heat treatment was performed for bonding in a vacuum of 0.8 Pa or less at 800°C for twenty minutes.

After cooling, the laminated body was removed from the furnace to find that all the thermoelectric elements were bonded with the Cu electrode plates with sufficient strength. In addition, the interfaces between the thermoelectric elements and the bonding parts and the conditions in the bonding parts were examined. It was found that a ratio of pores was 2%. The ratio of pores (porosity) was measured as follows. In addition, voltage (at the time of maximum output), interface resistance, and maximum output of the thermoelectric conversion module were measured. The measuring methods are as follows. The measured results are shown in Table 5.

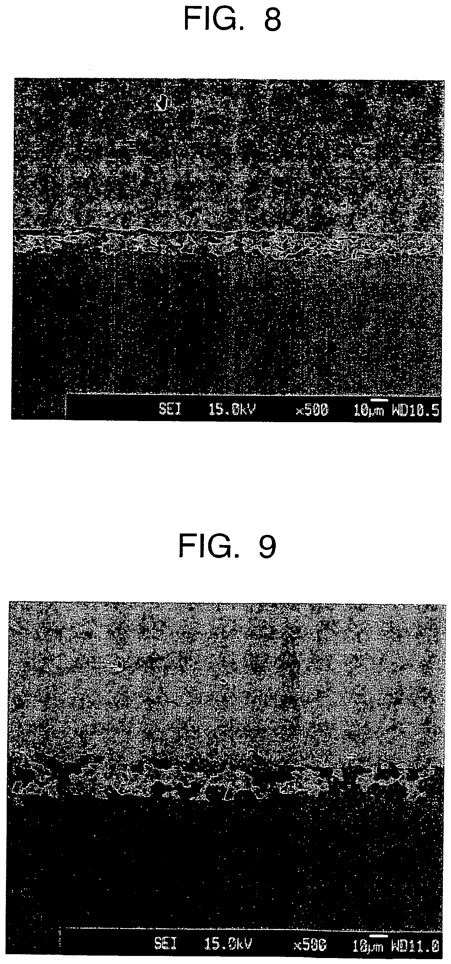

An arbitrary bonding cross section was selected from the bonding layer (brazing material layer) of the thermoelectric elements and the electrode plates to measure the ratio of pores (porosity). A total area (a total value of individual pore areas) of pores present in a width of 30 $\mu$m and a length of 500 $\mu$m on the side of the brazing material layer from the thermoelectric element of the bonding cross section was measured, and it was divided by the measured area to determine a ratio (%). This work was performed on three portions, and the average value was determined as the ratio of pores (porosity). The pores in an SEM observation image (SEM secondary electron image) are seen as darker images than other bonding parts (brazing material components) and can be identified. For reference, the SEM observation image of Example 40 (porosity of 11%) is shown in Fig. 8.

Examples 36 to 40

Thermoelectric conversion modules were produced in the same manner as in Example 35 except that pressures applied to the bonded surface when the thermoelectric elements and the Cu electrode plates were bonded were changed as shown in Table 5. The individual thermoelectric conversion modules were measured for a ratio of pores present in the bonded interface and the like, a voltage (at the time of maximum output), an interface resistance and maximum output. The measured results are shown in Table 5.

[Table 5]

|  | Bonding pressure (kPa) | Ratio of pores (%) | Voltage (V) | Interface resistance ($\Omega$) | Maximum output (W) |
|---|---|---|---|---|---|
| Example 35 | 30 | 4 | 4.21 | 0.26 | 16.1 |
| Example 36 | 80 | 2 | 4.28 | 0.27 | 16.5 |
| Example 37 | 50 | 3 | 4.22 | 0.26 | 16.2 |
| Example 38 | 20 | 5 | 4.17 | 0.27 | 15.7 |
| Example 39 | 10 | 7 | 3.70 | 0.34 | 11.6 |
| Example 40 | (no pressure) | 11 | 3.39 | 0.35 | 9.7 |

Examples 41 to 43

Thermoelectric conversion modules were produced in the same manner as in Example 35 except that the compositions of the bonding material (brazing material) for bonding the thermoelectric elements and the Cu electrode plates were changed as shown in Table 6. The individual thermoelectric conversion modules were measured for a ratio of pores present in the bonded interface and the like, a voltage (at the time of maximum output), an interface resistance and maximum output. The measured results are shown in Table 6.

[Table 6]

|  | Brazing material composition (% by mass) | | | | | | Ratio of pores (%) | Voltage (V) | Interface resistance ($\Omega$) | Maximum output (W) |
|---|---|---|---|---|---|---|---|---|---|---|
|  | Ag | Cu | Sn | In | Ti | C | | | | |
| E41 | 61.2 | 23.8 | 10.0 | - | 4.0 | 1.0 | 3 | 4.38 | 0.26 | 17.4 |
| E42 | 58.0 | 23.0 | - | 14.0 | 4.0 | 1.0 | 3 | 4.31 | 0.26 | 16.9 |
| E43 | 61.9 | 24.1 | 10.0 | - | 4.0 | 0 | 2 | 4.41 | 0.25 | 17.8 |
| E41 to E43= Example 41 to Example 43 | | | | | | | | | | |

Examples 44 to 48

Thermoelectric conversion modules were produced in the same manner as in Example 35 except that conditions for bonding the thermoelectric elements and the Cu electrode plates were changed as shown in Table 7. In Example 47 and Example 48, the bonding material (brazing material) having the same composition as in Example 43 was used.

The individual thermoelectric conversion modules were measured for a ratio of pores present in the bonded interface and the like, a voltage (at the time of maximum output), an interface resistance and maximum output. The measured results are shown in Table 7. For reference, the SEM observation image of Example 48 (porosity of 0%) is shown in Fig. 9.

[Table 7]

| | Bonding pressure (kPa) | Bonding atmosphere (Pa) | Surface roughness of device Ra ($\mu$m) | Thickness of brazing material layer ($\mu$m) | Ratio of pores (%) | Voltage (V) | Interface resistance ($\Omega$) | Maximum output (W) |
|---|---|---|---|---|---|---|---|---|
| E44 | 30 | 0.1 | 1.3 | 6 | 3 | 4.40 | 0.26 | 17.6 |
| E45 | 30 | 0.8 | 0.5 | 6 | 2 | 4.37 | 0.25 | 17.5 |
| E46 | 30 | 0.8 | 1.3 | 12 | 2 | 4.33 | 0.26 | 17.2 |
| E47 | 30 | 0.1 | 0.5 | 12 | 0.5 | 4.44 | 0.25 | 18.1 |
| E48 | 80 | 0.1 | 0.5 | 12 | 0 | 4.45 | 0.24 | 18.3 |
| E44 to E48 = Example 44 to Example 48 | | | | | | | | |

It is apparent from Table 5, Table 6 and Table 7 that the thermal resistance is decreased by decreasing the ratio of pores present in the interface between the thermoelectric element and the bonding material, so that heat can be conducted to the thermoelectric element well and efficiently. Therefore, a temperature difference between both ends of the thermoelectric element becomes substantially high, so that it is possible to improve output and energy conversion efficiency. The ratio of pores present in the bonded interface and the like can be decreased by increasing a bonding pressure, enhancing the decompression degree of the bonding atmosphere and smoothening the bonded surfaces. Inclusion of a small amount of carbon (for example, 0.5 to 5% by mass) into the bonding material (brazing material) improves coating properties, but in order to decrease the ratio of pores, for example, the carbon amount is preferably decreased to 1% by mass or less (including zero).

Example 49

The heat exchanger shown in Fig. 4 was produced according to the following procedure. A heat-resistant steel material was used to produce gas passages for high-temperature waste gas. And, corrosion-resistant steel material was used to produce water passages for the cooling water. The thermoelectric conversion modules of Example 1 were connected and disposed in series between the gas passages and the water passages to obtain a heat exchanger having a thermoelectric conversion module. When the heat exchanger having the thermoelectric conversion module was incorporated into the waste incineration system as shown in, for example, Fig. 5, the exhaust heat of the waste incinerator diffused into the atmosphere by performing the incineration treatment of general waste, combustible wastes and the like can be utilized.

In addition, the above-described heat exchanger having the thermoelectric conversion module was mounted in the middle of the exhaust pipe (exhaust gas passage) of an automobile engine to configure a thermoelectric power generating system. In the thermoelectric power generating system, DC power is derived from the thermal energy of the exhaust gas by the thermoelectric conversion module and regenerated into the storage battery mounted on an automobile. Thus, driving energy of an AC generator (alternator) mounted on the automobile is reduced, and the fuel consumption rate of the automobile can be improved.

The heat exchanger of Example described above applies water cooling, but a fin may be disposed on a cooling side to cool by air cooling. For example, such an air-cooling type heat exchanger can be applied to a combustion heating system to realize a combustion heating system which does not require supply of electric energy from outside. In other words, a combustion heating system which is provided with a combustion portion for burning a fuel such as petroleum-based liquid fuel, gas fuel or the like, and an air blowing unit which accommodates the combustion portion and has openings for discharging air including heat generated by the combustion portion toward the front of the system has an air-cooled heat exchanger disposed above the combustion portion. Such a combustion heating system can obtain DC power by the thermoelectric conversion module from part of the heat of the combustion gas to drive an air blowing fan which is within the air blowing unit.

INDUSTRIAL APPLICABILITY

The thermoelectric conversion module of the invention has thermoelectric elements made of a thermoelectric material which has as a main phase an intermetallic compound having an MgAgAs type crystalline structure and electrode members bonded with a bonding material containing at least one active metal selected from Ti, Zr, Hf, Ta, V and Nb. Thus, the strength, reliability, electrical conductivity, thermal conductance and the like of bonding parts can be enhanced. According to the present invention, it is possible to provide the thermoelectric conversion module which exerts a good thermoelectric conversion function under a high temperature of, for example, 300°C or more, a heat exchanger using such a thermoelectric conversion module, and a thermoelectric power generating system.

**Claims**

**1.** A thermoelectric conversion module (10), comprising:

a first electrode member (13) arranged on a high-temperature side; and a second electrode member (14) arranged on a low-temperature side to face the first electrode member;
a thermoelectric element (11,12) arranged between the first electrode member and the second
electrode member and made of a thermoelectric material including as a main phase an intermetallic compound having an MgAgAs crystalline structure ; and
bonding parts (17) for electrically and mechanically connecting the thermoelectric element to the
first and second electrode members, **characterized by** a bonding material which contains an Ag-Cu alloy or Ni as a main component and at least one active metal selected from Ti, Zr, Hf, Ta, V and Nb in a range of 1% by mass or more and 10% by mass or less; wherein the first electrode material is made of a metal material which contains at least one element selected from Cu, Ag and Fe;
the second electrode material is made of a metal material which contains at least one element selected from Cu, Ag and Fe;
the thermoelectric material has a composition represented by a general formula:

$$A_x B_y X_{100-x-y}$$

where, A is at least one element selected from group 3 elements, group 4 elements and group 5 elements, B is at least one element selected from group 7 elements, group 8 elements, group 9 elements and group 10 elements, X is at least one element selected from group 13 elements, group 14 elements and group 15 elements, and x and y are numerals satisfying $25 \leq x \leq 50$ atomic percent, $25 \leq y \leq 50$ atomic percent and $x+y \leq 75$ atomic percent.

**2.** The thermoelectric conversion module according to claim 1, wherein the thermoelectric material has a composition represented by a general formula:

$$A1_x B1_y X1_{100-x-y}$$

where, A1 is at least one element selected from Ti, Zr, Hf and rare earth element, B1 is at least one element selected from Ni, Co and Fe, X1 is at least one element selected from Sn and Sb, and x and y are numerals satisfying $30 \leq x \leq 35$ atomic percent, and $30 \leq y \leq 35$ atomic percent.

**3.** The thermoelectric conversion module according to claim 1 or 2, wherein the bonding material contains the active metal in a range of 1% by mass or more and 10% by mass or less, at least one element selected from Sn, In, Zn, Cd and C in a range of 40% by mass or less (including zero), and the balance of the Ag-Cu alloy.

**4.** The thermoelectric conversion module according to anyone of claims 1 to 3, wherein a ratio of pores present in an interface between the thermoelectric element and the bonding part and in the bonding part is 10% or less.

**5.** The thermoelectric conversion module according to claim 4, wherein the ratio of pores is 5% or less.

**6.** The thermoelectric conversion module according to anyone of claims 1 to 5, wherein an alloy layer of the active metal and the constituent element of the thermoelectric element is formed in an interface between the thermoelectric element and the bonding part.

**7.** The thermoelectric conversion module according to claim 6, wherein the alloy layer contains at least one element selected from Ni, Co, Fe, Y, La, Ce, Pr, Nd, Sm, Gd, Tb, Dy, Ho, Er, Tm, Yb, Lu, Sn and Sb as the constituent element of the thermoelectric element.

**8.** The thermoelectric conversion module according to anyone of claims 1 to 7, further comprising:

insulating heat-conducting plates (15,16) which are arranged on surfaces opposite to those of the first and second electrode members bonded with the thermoelectric element and made of a ceramics member which contains at least one selected from silicon nitride, aluminum nitride, silicon carbide, alumina and magnesia as a main component.

**9.** The thermoelectric conversion module according to claim 8, wherein the insulating heat-conducting plates are bonded to the first and second electrode members via the bonding material.

**10.** The thermoelectric conversion module according to anyone of claims 1 to 9, wherein the thermoelectric element has a p-type thermoelectric element and a n-type thermoelectric element arranged alternately, and the p-type thermoelectric element and the n-type thermoelectric element are connected in series by the first and second electrode members.

**11.** A heat exchanger (30), comprising:

a heating surface;
a cooling surface; and
the thermoelectric conversion module arranged between the heating surface and the cooling surface and in accordance with anyone of claims 1 to 10.

**12.** A thermoelectric power generating apparatus (40), comprising:

the heat exchanger according to claim 11; and
a heat supply portion for supplying the heat exchanger with heat,
wherein the heat supplied by the heat supply portion is converted into electric power by the thermoelectric conversion module of the heat exchanger to generate power.

**13.** The thermoelectric power generating apparatus according to claim 12, wherein the heat supply portion has a waste gas line of an incinerator, an inner water pipe of a boiler, an exhaust pipe of an automobile engine, or a combustion portion of a combustion heating device.

**14.** The heat exchanger according to claim 11, wherein the heating surface includes a gas passage for high-temperature waste gas composed of a heat-resistant steel material.

**Patentansprüche**

**1.** Thermoelektrisches Wandlermodul (10), umfassend:

ein erstes Elektrodenbauteil (13), das auf einer Hochtemperaturseite angeordnet ist; und ein zweites Elektrodenbauteil (14), das so auf einer Niedertemperaturseite angeordnet ist, dass es dem ersten Elektrodenbauteil zugewandt ist;
ein thermoelektrisches Element (11, 12), das zwischen dem ersten Elektrodenbauteil und dem zweiten Elektrodenbauteil angeordnet ist und aus einem thermoelektrischen Material hergestellt ist, das eine intermetallische Verbindung, die eine MgAgAs Kristallstruktur aufweist, als Hauptphase enthält;
und Verbindungsteile (17), um das thermoelektrische Element elektrisch und mechanisch mit den ersten und zweiten Elektrodenbauteilen zu verbinden, **gekennzeichnet durch** ein Verbindungsmaterial, das eine Ag-Cu-Legierung oder Ni als Hauptkomponente und mindestens ein aktives Metall, ausgewählt aus Ti, Zr, Hf, Ta, V und Nb in einem Bereich von 1 Massen% oder mehr und 10 Massen% oder weniger, enthält; wobei das Material der ersten Elektrode aus einem metallischen Material hergestellt ist, das mindestens ein Element, ausgewählt aus Cu, Ag und Fe, enthält;

das Material der zweiten Elektrode aus einem metallischen Material hergestellt ist, das mindestens ein Element, ausgewählt aus Cu, Ag und Fe, enthält; das thermoelektrische Material eine Zusammensetzung aufweist, die durch die folgende allgemeine Formel dargestellt wird:

$$A_xB_yX_{100-x-y}$$

worin A mindestens ein Element, ausgewählt aus Gruppe 3-Elementen, Gruppe 4-Elementen und Gruppe 5-Elementen ist, B mindestens ein Element, ausgewählt aus Gruppe 7-Elementen, Gruppe 8-Elementen, Gruppe 9-Elementen und Gruppe 10-Elementen ist, X mindestens ein Element, ausgewählt aus Gruppe 13-Elementen, Gruppe 14-Elementen und Gruppe 15-Elementen ist, und x und y Zahlen sind, die $25 \leq x \leq 50$ Atomprozent, $25 \leq y \leq 50$ Atomprozent und $x+y \leq 75$ Atomprozent bedeuten.

2. Thermoelektrisches Wandlermodul gemäß Anspruch 1, wobei das thermoelektrische Material eine Zusammensetzung aufweist, die durch die folgende allgemeine Formel dargestellt wird:

$$A1_xB1_yX1_{100-x-y}$$

worin A1 mindestens ein Element, ausgewählt aus Ti, Zr, Hf und einem seltenen Erdmetallelement ist, B1 mindestens ein Element, ausgewählt aus Ni, Co und Fe ist, X1 mindestens ein Element, ausgewählt aus Sn und Sb ist, und x und y Zahlen sind, die $30 \leq x \leq 35$ Atomprozent und $30 \leq y \leq 35$ Atomprozent bedeuten.

3. Thermoelektrisches Wandlermodul gemäß Anspruch 1 oder 2, wobei das Verbindungsmaterial das aktive Metall in einem Bereich von 1 Massen% oder mehr und 10 Massen% oder weniger, mindestens ein Element, ausgewählt aus Sn, In, Zn, Cd und C in einem Bereich von 40 Massen% oder weniger (einschließlich 0) und die Ag-Cu-Legierung als Rest enthält.

4. Thermoelektrisches Wandlermodul gemäß mindestens einem der Ansprüche 1 bis 3, wobei ein Anteil an Poren, die an einer Grenzfläche zwischen dem thermoelektrischen Element und dem Verbindungsteil und in dem Verbindungsteil vorhanden sind, 10% oder weniger beträgt.

5. Thermoelektrisches Wandlermodul gemäß Anspruch 4, wobei der Anteil an Poren 5% oder weniger beträgt.

6. Thermoelektrisches Wandlermodul gemäß mindestens einem der Ansprüche 1 bis 5, wobei eine Legierungsschicht des aktiven Metalls und der Elemente, die Bestandteile des thermoelektrischen Elements sind, in einer Grenzfläche zwischen dem thermoelektrischen Element und dem Verbindungsteil gebildet ist.

7. Thermoelektrisches Wandlermodul gemäß Anspruch 6, wobei die Legierungsschicht mindestens ein Element, ausgewählt aus Ni, Co, Fe, Y, La, Ce, Pr, Nd, Sm, Gd, Tb, Dy, Ho, Er, Tm, Yb, Lu, Sn und Sb als Bestandteil des thermoelektrischen Elements enthält.

8. Thermoelektrisches Wandlermodul gemäß mindestens einem der Ansprüche 1 bis 7, ferner umfassend:

isolierende wärmeleitende Platten (15, 16), die auf Oberflächen angeordnet sind, die denen der ersten und zweiten Elektrodenbauteile, die mit dem thermoelektrischen Element verbunden sind, gegenüberliegen und aus einem Keramikelement hergestellt sind, das mindestens einen Vertreter ausgewählt aus Siliziumnitrid, Aluminiumnitrid, Siliziumcarbid, Aluminiumoxid und Magnesiumoxid als Hauptkomponente enthält.

9. Thermoelektrisches Wandlermodul gemäß Anspruch 8, wobei die isolierenden wärmeleitenden Platten mit den ersten und zweiten Elektrodenbauteilen über das Verbindungsmaterial verbunden sind.

10. Thermoelektrisches Wandlermodul gemäß mindestens einem der Ansprüche 1 bis 9, wobei das thermoelektrische Element ein thermoelektrisches Element vom p-Typ und ein thermoelektrisches Element vom n-Typ aufweist, die abwechselnd angeordnet sind, und das thermoelektrische Element vom p-Typ und das thermoelektrische Element vom n-Typ durch die ersten und zweiten Elektrodenbauteile in Reihe geschaltet sind.

**11.** Wärmetauscher (30), umfassend:

eine Heizfläche;
eine Kühlfläche; und
das thermoelektrische Wandlermodul, das zwischen der Heizfläche und der Kühlfläche angeordnet ist und mindestens einem der Ansprüche 1 bis 10 entspricht.

**12.** Thermoelektrische Stromerzeugungsvorrichtung (40), umfassend:

den Wärmetauscher gemäß Anspruch 11; und einen Wärmezufuhrteil, um dem Wärmetauscher Wärme zuzuführen, wobei die Wärme, die durch den Wärmezufuhrteil zugeführt wird, durch das thermoelektrische Wandlermodul des Wärmetauschers in elektrischen Strom umgewandelt wird, und so Strom erzeugt wird.

**13.** Thermoelektrische Stromerzeugungsvorrichtung gemäß Anspruch 12, wobei der Wärmezufuhrteil eine Abgasleitung einer Verbrennungsanlage, eine innere Wasserleitung eines Kessels, einen Auspuff eines Kraftfahrzeugmotors oder einen Verbrennungsteil einer Verbrennungsheizvorrichtung aufweist.

**14.** Wärmetauscher gemäß Anspruch 11, wobei die Heizfläche einen Gasweg für Hochtemperatur-Abgas enthält, der aus einem wärmebeständigen Stahlmaterial aufgebaut ist.

## Revendications

**1.** Module de conversion thermoélectrique (10), comprenant :

un premier élément d'électrode (13) agencé sur un côté haute température ; et un second élément d'électrode (14) agencé sur un côté basse température pour faire face au premier élément d'électrode ;
un élément thermoélectrique (11, 12) agencé entre le premier élément d'électrode et le second élément d'électrode et fait d'un matériau thermoélectrique incluant, en tant que phase principale, un composé intermétallique possédant une structure cristalline MgAgAs ; et
des parties de liaison (17) pour connecter électriquement et mécaniquement l'élément thermoélectrique aux premier et second éléments d'électrode, **caractérisé par** un matériau de liaison qui contient un alliage Ag-Cu ou du Ni en tant que composant principal et au moins un métal actif sélectionné parmi Ti, Zr, Hf, Ta, V et Nb dans une plage de 1 % en masse ou plus et 10 % en masse ou moins; dans lequel
le premier matériau d'électrode est fait d'un matériau métallique qui contient au moins un élément sélectionné parmi Cu, Ag et Fe ;
le second matériau d'électrode est fait d'un matériau métallique qui contient au moins un élément sélectionné parmi Cu, Ag et Fe ;
le matériau thermoélectrique possède une composition représentée par une formule générale :

$$A_x B_y X_{100-x-y},$$

où A est au moins un élément sélectionné parmi des éléments de groupe 3, des éléments de groupe 4 et des éléments de groupe 5, B est au moins un élément sélectionné parmi des éléments de groupe 7, des éléments de groupe 8, des éléments de groupe 9 et des éléments de groupe 10, X est au moins un élément sélectionné parmi des éléments de groupe 13, des éléments de groupe 14 et des éléments de groupe 15, et x et y sont des nombres satisfaisant $25 \leq x \leq 50$ pour cent atomique, $25 \leq y \leq 50$ pour cent atomique et $x + y \leq 75$ pour cent atomique.

**2.** Module de conversion thermoélectrique selon la revendication 1, dans lequel le matériau thermoélectrique possède une composition représentée par une formule générale :

$$A1_x B1_y X1_{100-x-y},$$

où, A1 est au moins un élément sélectionné parmi Ti, Zr, Hf et un élément des terres rares, B1 est au moins un élément sélectionné parmi Ni, Co et Fe, X1 est au moins un élément sélectionné parmi Sn et Sb, et x et y sont des nombres satisfaisant $30 \leq x \leq 35$ pour cent atomique, et $30 \leq y \leq 35$ pour cent atomique.

3. Module de conversion thermoélectrique selon la revendication 1 ou 2, dans lequel le matériau de liaison contient le métal actif dans une plage de 1 % en masse ou plus et 10 % en masse ou moins, au moins un élément sélectionné parmi Sn, In, Zn, Cd et C dans une plage de 40 % en masse ou moins (y compris zéro), et le reste de l'alliage Ag-Cu.

4. Module de conversion thermoélectrique selon l'une quelconque des revendications 1 à 3, dans lequel un rapport de pores présents dans une interface entre l'élément thermoélectrique et la partie de liaison et dans la partie de liaison est 10 % ou moins.

5. Module de conversion thermoélectrique selon la revendication 4, dans lequel le rapport de pores est 5 % ou moins.

6. Module de conversion thermoélectrique selon l'une quelconque des revendications 1 à 5, dans lequel une couche d'alliage du métal actif et de l'élément constitutif de l'élément thermoélectrique est formée dans une interface entre l'élément thermoélectrique et la partie de liaison.

7. Module de conversion thermoélectrique selon la revendication 6, dans lequel la couche d'alliage contient au moins un élément sélectionné parmi Ni, Co, Fe, Y, La, Ce, Pr, Nd, Sm, Gd, Tb, Dy, Ho, Er, Tm, Yb, Lu, Sn et Sb en tant que l'élément constitutif de l'élément thermoélectrique.

8. Module de conversion thermoélectrique selon l'une quelconque des revendications 1 à 7, comprenant en outre :

   des plaques thermo-conductrices isolantes (15, 16) qui sont agencées sur des surfaces opposées à celles des premier et second éléments d'électrode liés à l'élément thermoélectrique et faites d'un élément en céramique qui contient au moins l'un sélectionné parmi du nitrure de silicium, du nitrure d'aluminium, du carbure de silicium, de l'alumine et de la magnésie en tant que composant principal.

9. Module de conversion thermoélectrique selon la revendication 8, dans lequel les plaques thermo-conductrices isolantes sont liées aux premier et second éléments d'électrode par l'intermédiaire du matériau de liaison.

10. Module de conversion thermoélectrique selon l'une quelconque des revendications 1 à 9, dans lequel l'élément thermoélectrique possède un élément thermoélectrique de type p et un élément thermoélectrique de type n agencés en alternance, et l'élément thermoélectrique de type p et l'élément thermoélectrique de type n sont connectés en série par les premier et second éléments d'électrode.

11. Échangeur de chaleur (30), comprenant :

   une surface de chauffage ;
   une surface de refroidissement ; et
   le module de conversion thermoélectrique agencé entre la surface de chauffage et la surface de refroidissement et selon l'une quelconque des revendications 1 à 10.

12. Appareil thermoélectrique de génération de puissance (40), comprenant :

   l'échangeur de chaleur selon la revendication 11; et
   une portion d'alimentation en chaleur pour fournir de la chaleur à l'échangeur de chaleur,
   dans lequel la chaleur fournie par la portion d'alimentation en chaleur est convertie en puissance électrique par le module de conversion thermoélectrique de l'échangeur de chaleur pour produire de la puissance électrique.

13. Appareil thermoélectrique de génération de puissance selon la revendication 12, dans lequel la portion d'alimentation en chaleur possède une conduite de gaz de rejet d'un incinérateur, un tuyau d'eau intérieur d'une chaudière, un tuyau d'échappement d'un moteur d'automobile ou une portion de combustion d'un dispositif de chauffage à combustion.

14. Échangeur de chaleur selon la revendication 11, dans lequel la surface de chauffage inclut un passage de gaz pour un gaz de rejet haute température composé d'un matériau en acier résistant à la chaleur.

# FIG. 1

# FIG. 2

# FIG. 3

# FIG. 4

# FIG. 5

# FIG. 6A

(TNA) COMP 15.0kV

# FIG. 6B

# FIG. 6C

12

22

17

13

Ti Amount

Large

⊢——⊣ 20 µ m

# FIG. 7A

(TNR) COMP 15.0kV

# FIG. 7B

# FIG. 7C

12

23

13

Ti Amount

Large

20 μm

# FIG. 8

# FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001168402KOKAI A
- JP 2001352107KOKAI A
- JP 2002203993KOKAI A
- JP 11068172 A

### Non-patent literature cited in the description

- *J. Phys. Condens. Matter,* 1999, vol. 11, 1697-1709
- Thermoelectric properties of half-heusler phases: ErNi1-xCuxSb, YNi1-xCuxSb and ZrxHfyTizNiSn. **SPORTOUCH S et al.** EIGHTEEN INTERNATIONAL CONFERENCE ON THERMOELECTRICS. IEEE, 29 August 1999, 344-347